Europäisches Patentamt

European Patent Office

Office européen des brevets

(11) Veröffentlichungsnummer: **0 229 256**

**A2**

(12) **EUROPÄISCHE PATENTANMELDUNG**

(21) Anmeldenummer: **86115721.2**

(22) Anmeldetag: **12.11.86**

(51) Int. Cl.4: **H05K 13/08 , H05K 13/04**

(30) Priorität: **13.11.85 DE 3540316**

(43) Veröffentlichungstag der Anmeldung:
**22.07.87 Patentblatt 87/30**

(84) Benannte Vertragsstaaten:
**AT BE CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Herberich, Wolfgang, Dipl.-Ing.**
**Nördlinger Strasse 24**
**D-8901 Königsbrunn(DE)**
Erfinder: **Degle, Walter, Dipl.-Ing.**
**Entenweg 3**
**D-8903 Bobingen(DE)**
Erfinder: **Bahnsen, Heiner, Dipl.-Ing.**
**Robert-Koch-Ring**
**D-4290 Bocholt(DE)**
Erfinder: **Bolzmann, Olaf-Ragnar, Dipl.-Ing.**
**Oskar-von-Miller-Strasse 83**
**D-8900 Augsburg 22(DE)**

(54) **Fertigungsanlage zur automatischen Montage und Prüfung elektronischer Flachbaugruppen.**

(57) Die Erfindung bezieht sich auf eine Fertigungsanlage zur automatischen Montage und Prüfung elektronischer Flachbaugruppen. Bisher ist es nur möglich, Flachbaugruppen losweise zu fertigen, ohne daß Bedarf eine rasche Umstellung auf eine andere Fertigungstype wirtschaftlich möglich ist. Dieser Nachteil wird bei der Erfingung dadurch vermieden, daß alle eforderlichen Betriebsmittel - (Bauteile, Werkzeuge, Montage-und Prüfeinrichtungen) im "Direktzugriff" (Rüstzeit gegen Null) der in der Fertigungslinie über eine umfangreiche Rechnerhirarchie gesteuert wird, in der Montage-und Prüflinie zur Verfügung stehen. Ein Leitrechner verwaltet die den einzelnen Bearbeitungsstationen (3, 4, 5) zugeordneten Zellenrechner, die ihrerseits die Maschinenrechner ansteuern. Das Transportsystem verfügt über eine eigen Steuerung. Die einzelnen Teile des Transportsystem bestehen jeweils aus einem "Streckenkopf" (8, 6, 13) zum Umsetzen des Bestückgutes auf verfahrensspezifische Werkstückträger bei gleichzeitigem Aufbringen der jeweils ersten Zieladresse zwecks Zuleitung mittels Weichen zu den einzelnen Bearbeitungsstationen (3, 4, 5).

FIG 1

## Fertigungsanlage zu, automatischen Montage und Prüfung elektronischer Flachbaugruppen

Die Erfindung betrifft eine Fertigungsanlage zur automatiachen Montage und Prüfung elektronischer Flanchbaugruppen unter Verwendung programgesteuerte Bestückungs-, Löt-und Prüfautomaten sowie eines mechanischen Transportsystems, wobei jeweils mehrere gleichartige Bearbeitungsstationen zu sogenannten Zellen zusammengefaßt sind, wobei die Steuerung der Einzelteile, wie z.B. Leiterplatten, Bauelemente oder mechanische Teile, über einen Leitrechner in Zusammenarbeit mit jeder Zelle zugeordneten Zellenrechnern und mit Hilfe an den Einzelteilen anbringbaren Kannzeichnungen erfolgt.

Die Senkung von Beständen, Erhöhung der Qualität und Vermeidung von technisch und dispositiv bedingter Nachrüstung bzw. Verwürfen ist ein wesentlicher Beitrag zur Steigerung der Produktivität. In besonderem Maße gilt dies für die Produktion elektronischer Anlagen, die unter Zusammensetzung hochwertiger Komponenten gefertigt werden. Schwerpunkte derartiger Betriebes ist die Flachbaugruppen-Fertigung ung Prüfung.

Bestandskosten werden verursacht durch Durchlaufbestände (in direkter Abhängigkeit von der Durchlaufzeit) und Modullagerbestände an fertig geprüften Flachbaugruppen, die noch nicht von der nachgeschalteten Anlagenmontage abgerufen werden können, weil die Typenstruktur noch nicht vollständig ist. Nachbearbeitungskosten werden vermindert durch die angestrebte Fertigungsqualität von > 95 % fehlerfreier Flachbaugruppen vor der ersten Prüfung. Nachrüst-und Verwurfskosten werden verursacht durch Flachbaugruppen, die nach Fertigstellung infolge geänderter Disposition nicht mehr benötigt werden bzw. zum Zeitpunkt des Bedarfs technisch überholt sind. Das Risiko steht in direkter Abhängigkeit von der Gesamtlaufzeit.

Es ist bekannt, Flachbaugruppen losweise zu fertigen, wobei der Grund für diese Losbildung darin liegt, daß zur Fertigung eines bestimmten Flachbaugruppentyps die Bestück-und Prüfmaschinen speziell gerüstet werden müssen. Zum Rüstvorgang gehört das Versorgen der Maschinen mit Material (Bauelemente) wie auch mit den Informationsmengen, die den Arbeitsablauf definieren. Weil die Rüstzeit heute im Vergleich zum eigentlichen Fertigungsprozeß relativ hoch ist, muß versucht werden, nach Aufwendung einer Rüstzeit möglichst viele gleichartige Flachbaugruppentypen hintereinander zu fertigen (Losbildung). Bekannte Flachbaugruppenfertigungseinrichtungen fertigen in einem Zyklus von z.B. mehreren Wochen das benötigte Spektrum an Flachbaugruppentypen und -mengen und liefern es an ein Flachbaugruppenlager aus, dem die nachfolgende Montagewerkstatt die Flachbaugruppen wahlfrei entnehmen kann. Dieses Pufferlager ist erforderlich, um von einem bestimmten Flachbaugruppentyp so viel Stück vorrätig zu halten, weil erst nach dem genannten Zeitraum von mehreren Wochen dieser gleiche Typ wieder gefertigt werden soll.

Die Lose fassen den Bedarf einer Periode der Anlagenmontage (z.B. Monatsscheibe) zusammen. Die Fertigungs-und Prüfeinrichtungen müssen für jedes Los neu eingerichtet werden. Ein Los wird zum nachgeschalteten Produktionsschritt erst dann weitergegeben, wenn das letzte Exemplar bearbeitet ist. Die Zusammenfassung von Flachbaugruppen gleichen Typs ist eine zwingende Notwendigkeit, um die Rüstzeit in vertretbarem Verhältnis zur produktiven Zeit zu halten. Alle bekannten Aktivitäten bemühen sich um graduelle Verbesserung des heutigen Zustandes, ohne sich von der Grundbedingung der Losbildung freizumachen. Eine Durchlaufzeit in der Größenordnung von z.B. zwei Wochen für die Flachbaugruppenfertigung (von Materialabruf bis zur abgeschlossenen elektrischen Prüfung) scheint eine natürliche Untergrenze zu sein. Dieser Wert ist aber nur zu erreichen, wenn die Losgröße bis an die Grenze reduziert wird, bei der der Rüstaufwand wegen seines exponentiellen Ansteigens wirtschaftlich nicht mehr vertretbar wird (Losgrößen 15 bis 20 Stück).

In der deutschen Patentanmeldung P 34 18 210 wird bereits ein Verfahren zur rüstfreien Fertigung von Flachbaugruppen ohne Zwang zur Losbildung beschrieben, bei der der Dertigungsprozeß weitgehend automatisiert ist. Die zur Montage - (Bestücken und Löten) erforderlichen Bauelemente einerseits wie auch die Informationsmengen, sowohl zur Montage als auch zur Prüfung einzelner Flachbaugruppenexemplare, befinden sich im wahlfreien Zugriff der Montage-und Prüfstation. Montage-und Prüfstationen sind selbst rechnergeführte Einrichtungen, wobei zusätzlich der Transport der Produkte con Station zu Station durch weitere Rechner (Zellenrechner) geführt wird und gesamte Ferigungsprizeß, beinnedn von der Eingabe der Leiterplatte bis zur Ablieferung der fertig bestückten geprüften Flachbaugruppe, an die weiterverarbeitende Abteilung von einem, dem Zekkenrichner nochmals überlagerten Leitrechner kooriniert wird.

Aufgabe der vorliegenden Erfindung ist es, eine Fertigungsanlage mit geeigneten Transportsystemen für das oben angegebene Verfahren zur automatischen Montage und Prüfung elektronischer Flachbaugruppen zu schaffen.

Die Fertigungsanlage ist gemäß der Erfindung derart ausgebildet, daß der erste Teil des Transportsystems aus zwei vorzugsweise übereinander angeordneten getrennten horizontalen Endlosbändern zum getrennten Transport von Leiterplatten bzw. Flachbaugruppen und damit zu bestückenden Bauteilen, mit seitlich in Transportrichtung über vom Leitrechner gesteuerten Weichen erreichbaren Bearbeitungsstationen sowie einem ersten Streckenkopf besteht, auf dem die Leiterplatten auf einen ersten mit einer ersten Zieladresse versehenen Werkstückträger zur Bestückung aufbringbar sind, wobei in jeder Bearbeitungsstation Mittel vorgesehen sind, durch die die erreichte Zieladresse löschbar und die jeweils neue Zieladresse aufbringbar ist, daß an diesem ersten Streckenkopf außerdem die Bauteile einzeln oder satzweise edenfalls mit ihrer Zieladresse versehbar sind, daß in den Bearbeitungsstationen außerdem Puffe zur Ablage auflaufender, zu bestückender Leiterplatten bzw. Flachbaugruppen und Bauteilen vorgesehen sind, daß ein zweiter Streckenkopf vorgesehen ist, an dem die teilbestückten Flachbaugruppen auf einem zweiten, die letzte Zieladresse übernehmenden, Werkstückträger zum Löten umsetzbar sind, von dem aus sie dem zweiten Teil des Transportsystems, das zu den Lötstationen führt und aus einer oder mehreren nebeneinander angeordneten Transportbändern besteht, zugeführt sind, daß ein dritter Streckenkopf vorgesehen ist, an dem die von der Lötstation kommenden teilbestückten Flachbaugruppen auf einem dritten Werkstückträger für Prüfzwecke umgesetzt und auf einem dritten Teil des Transportsystems, das aus einem in einer Ebene angeordneten Endlosband besteht, den Endmontage-und Prüfstationen zugeführt sind.

In weiterer Ausgestaltung sieht die Erfindung vor, daß der erste Teil des Transportsystems aus einem übereinander angeordneten Endlosband zum Transport von Leiterplatten bzw. Flachbaugruppen, mit seitlich in Transportrichtung über vom Leitrechner gesteuerten Weichen erreichbaren Bearbeitungsstationen sowie einem ersten Streckenkopf besteht, auf dem die Leiterplatten auf einen ersten mit einer ersten Zieladresse versehenen Werkstückträger zur Bestückung aufbringbar sind, wobei in jeder Bearbeitungsstation Mittel vorgesehen sind, durch die die erreichte Zieladresse löschbar und die jeweils neue Zieladresse aufbringbar ist, daß in den Bearbeitungsstationen außerdem Puffer zur Ablage aufgelaufener, zu bestückender Leiterplatten bzw. Flachbaugruppen und Bauteile vorgesehen sind und daß die Bauteile über ein fahrerloses Transportsystem zu den einzelnen Bearbeitungsstationen gelangen, daß ein zweiter Streckenkopf vorgesehen ist, an dem die teilbestückten Flachbaugruppen auf einem zweiten, die letzte Zieladresse übernehmenden, Werkstoffträger zum Löten umsetzbar sind, von dem aus sie dem zweiten Teil des Transportsystems, das zu den Lötstationen führt und aus einer oder mehreren nebeneinander angeordneten Transportbändern besteht, zugeführt sind, daß ein dritter Streckenkopf vorgesehen ist, an dem die von der Lötstation kommenden bestückten Flachbaugruppen auf einem dritten Werkstückträger für Prüfzwecke umgesetzt, auf den dritten Teil des Transportsystems, das aus einem horizontal angeordneten Endlosband besteht, den Endmontage- und Prüfstationen zugeführt sind.

Durch diese Maßnahmen erhält man eine Fertigungsanlage für eine rüstfreie Fertigung, ohne Zwang zur Losbildung.

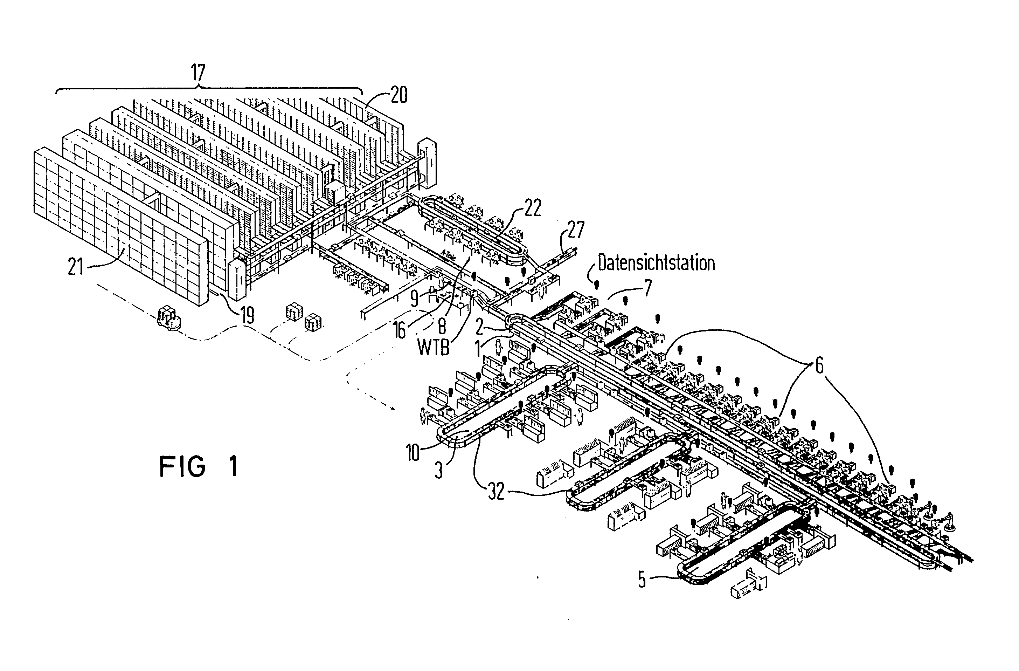

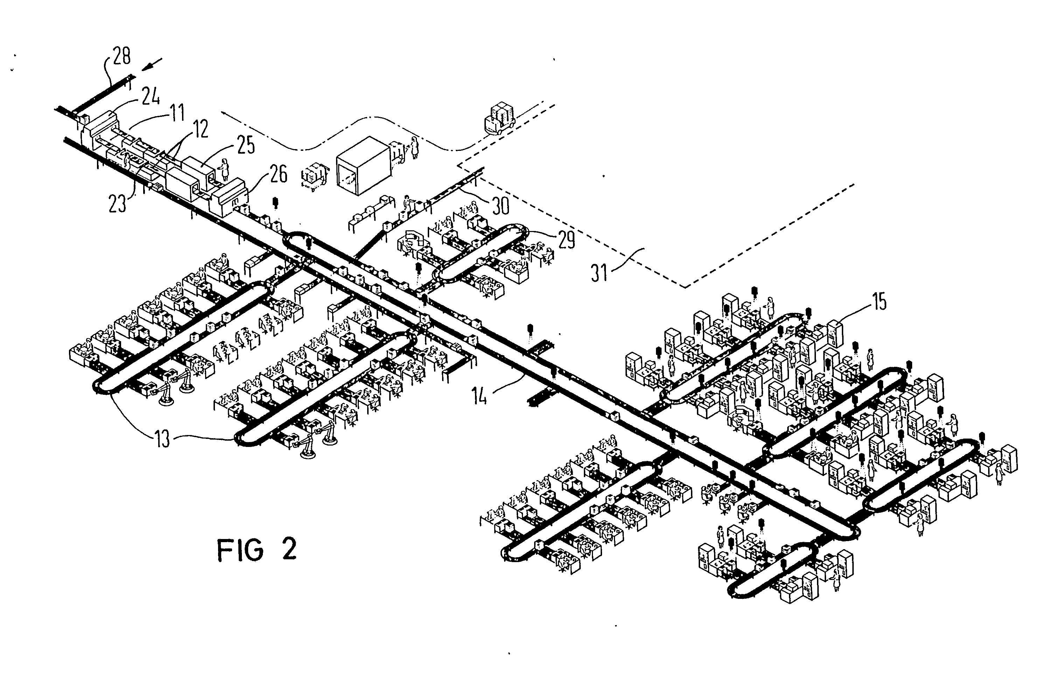

Anhand der Figuren 1 und 2 wird die Erfindung näher erläuert. Es zeigen:

FIG 1 den ersten Teil einer ersten Transportanlage mit dem Streckenkopf für den zweiten Teil der Transportanlage,

FIG 2 den zweiten und dritten Teil der ersten Transportanlage,

FIG 3 eine zweite Transportanlage.

Am ersten Streckenkopf 8 werden, wie in FIG 1 dargestellt, alle Teile angeliefert, die für die Erstellung einer Flachbaugruppe notwendig sind. Sowohl die Leiterplatten als auch die Werkstückträger WTB werden über ein gesteuertes bzw. steuerbares, fahrerloses Transportmittel FTS zu einem Leiterplatten-und Werkstückträgerpufferplatz 16 gebracht, an dem die Leiterplatten 9 auf den Werkstückträger WTB aufgebracht werden. Dabei kann eine oder bei Mehrfachbelegung auch mehrere Leiterplatten auf einem Werkstückträger WTB angeordnet sein. Gleichzeitig erfolgt an diesem Platz auch das Ausrichten und Codieren des jeweiligen Werkstückträgers WTB.

Das Lager 17 besteht aus mehreren Regalen mit dazwischenliegenden Lagergassen 19. Dabei sind Regale 20 für die Einlagerung von Kleinteilen und Regale 21 für die Einlagerung von Paletten vorgesehen. Je nach Bedarf werden entweder Einzelkleinteile oder bereits mit Kleinteilen bestückte Paletten, die für bestimmte Flachbaugruppentypen sortiert sind, aus dem Lager abgerufen und über ein eigenes Transportband zu den Bauelementevorbereitungsplätzen 22 rechnergesteuert transportiert. An den Bauelementevorbereitungsplätzen 22 werden die einzelnen Bauelemente für den manuellen Bestückungsvorgang vorbereitet und dann in Behältern sortiert an die jeweiligen Bearbeitungsstationen rechnergesteuert weitergeleitet.

Der erste Teil des Transportsystems für die Fertigungsanlage zur automatischen Erstellung und Prüfung elektroni scher Flachbaugruppen besteht aus zwei übereinander angeordneten Endlosbändern 1, 2. Dabei werden in der oberen Ebene 1 die Einzelbauteile bzw. die zu Losen sortierten Bauteile an die jeweiligen Bearbeitungsstationen transportiert, während in der unteren Ebene 2 die mit Leiterplatten 9 bestückten Werkstückträger WTB ebenfalls zu den Bearbeitungsstationen 3, 4, 5 gelangen. Diese Bearbeitungsstationen sind zu einzelnen Zellen zusammengefaßt, die seitlich neben dem Haupttransportbändern 1, 2 angeordnet sind und bei der jede Zelle wiederum zwei übereinander angeordnete Endlostransportbänder 32 enthält, an denen die einzelnen Bearbeitungsmaschinen angeordnet sind. Werden mehr Bauelemente bzw. Werkstückträger mit Leiterplatten angeliefert als von den Maschinen momentan bewältigt werden können, so können diese auf ein Puffer 10 ausgelagert werden. In der vorliegenden Figur sind drei in Transportrichtung hintereinander angeordnete Zellen gezeigt, wobei die erste Zelle 3 mit Dual-Inline-Package-Automaten, die zweite Zelle 4 mit Axialbestückungsmaschinen und die dritte Zelle 5 mit Radial-und Sonderbestückungsmaschinen ausgerüstet ist. Die Versorgung der einzelnen Maschinen mit Bauelementen werden in einer Trägereinheit, welche mit einer Zielcodierung versehen ist, wie bereits vorstehend beschrieben, angeliefert. Die Zielcodierung steuert die Trägereinheiten bedarfsmäßig zu den Bestückungsmaschinen. Danach gelangen die teilbestückten Flachbaugruppen zusammen mit dem Werkstückträger WTB zu einem weiteren Streckenkopf 6, der zwei Aufgaben zu erfüllen hat. Zunächst werden dort Teile, die nicht maschinell bestückbar sind, per Hand auf die Flachbaugruppen aufgebracht und anschließend wird die Umrüstung vom Werkstückträger für die Bestückung WTB auf einen zweiten Werkstückträger WTL für den Lötvorgang vorgenommen.

Von diesem Streckenkopf 6 aus gelangen die umgerüsteten Flachbaugruppen, wie in FIG 2 gezeigt, auf einem weiteren Transportband zu den Lötautomaten 23, die mehrfach vorhanden sein können. Dabei wird der ankommende Flachbaugruppenstapel zunächst in der Vorrichtung 24 entstapelt, anschließend kolofoniert und gelötet und danach Waschautomaten 25 zugeführt, denen eine Stapelvorrichtung 26 nachgeschaltet ist. Die so zu Stapeln versehenen Flachbaugruppen gelangen nunmehr zu einem dritten Streckenkopf 13, der wiederum zwei Aufgaben zu erfüllen hat. Zunächst wird dort die Endmontage der Flachbaugruppen vorgenommen und anschließend werden die Flachbaugruppen auf einen dritten Werkstückträger WTP für Prüfzwecke umgebettet. Daraufhin werden sie dem dritten Teil einer Transporteinrichtung zugeführt, die aus einem dritten nebeneinander laufenden Endlosband 14 besteht, an dessen Seiten wiederum Zellen angeordnet sind, die ebenfalls mit Endlosbändern ausgestattet sind, an denen aber nunmehr Prüfautomaten 15 für die einzelnen Prüfvorgänge aufgestellt sind. Nach der letzten Funktionsprüfung gelangen die für in Ordnung befundenen Baugruppen über ein Transportband 30 zur Gerätemontage 31, während fehlerhafte Flachbaugruppen in einer Diagnose-und Reparaturstation 29 repariert werden und anschließend ebenfalls über das Förderband 30 zur Gerätemontage 31 geführt sind.

Parallel zu der beschriebenen Transportanlage können weitere Transportanlagen vorgesehen sein, wobei die Abzweigung 27 am ersten Streckenkopf 8 angedeutet ist. Zum Lötvorgang werden diese parallel bestückten Flachbaugruppen dann an den gemeinsamen Lötautomaten 23 geführt, wobei die Einspeisung 28 dieser Flachbaugruppen vor dem Entstapelungsautomaten 24 in FIG 2 dargestellt erfolgt.

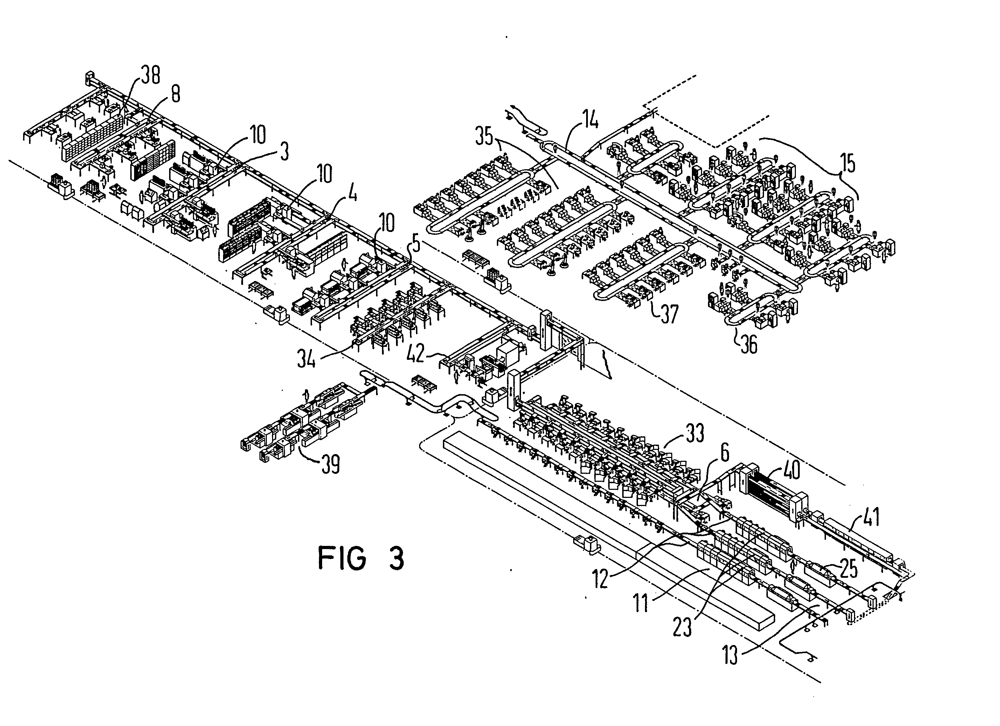

Eine weitere Möglichkeit des Aufbaus einer Fertigungsanlage zur automatischen Montage und Prüfung elektronischer Flachbaugruppen zeigt FIG 3. Der erste Teil der Anlage besteht aus einem übereinander angeordneten Endlosband mit Hinlauf in der oberen und Rücklauf in der unteren Ebene. Nach der Sonderzelle 38 werdem am ersten Streckenkopf 8 die noch unbestückten Leiterplatten 9 auf den Werkstückträger WTB für die Bestückung aufgebracht und mit entsprechender Codierung versehen. In der Bearbeitungsstation 3 werden Bauteil mit Daul-Inline-Gehäusen montiert, in der darauffolgenden Bearbeitungsstation 4 axiale Bauteile und im Anschluß daran in der Bearbeitungsstation 5 radiale Bauteile. Nach einer Vormontagezelle 34 zur Sonderbestückung und einer eventuellen weiteren Bestückung mit unbedrahteten Bauelementen in der Zelle 42 gelangen die teilweise bestückten Baugruppen über einen Handbestückungsplatz 33m an dem die nicht automatisch bestückbaren Elemente aufgebracht werden, an den zweiten Streckenkopf 6, wo sie von dem Werkstückträger für Bauelemente WTB abgenommen und auf einem Werkstückträger WTL, der zum Löten geeignet ist, neu aufgebracht werden. Anschließend werden die bestückten Leiterplatten 9 durch die Lötzelle 11 gefahren, die mehrere Lötstationen 23 enthalten, und die über die Bänder 12 mit dem zweiten Streckenkopf 6 und den Handbestückungsplätzen 33 verbunden sind. Zur Lötzelle 11 gehören auch noch die Wasch-und Bürststationen 25, die den einzelnen Lötautomaten nachgeschaltet sind. In der Nähe der Lötautomaten befindet sich auch das Lager für die Werkstückträger zum Löten, die nach dem Gebrauch über eine eigene Waschanlage 41 gesäubert werden.

Die nunmehr bestückten und verlöteten Leiterplatten werden in einem dritten Abschnitt zu Prüfautomaten 15 geführt. Die Prüfautomaten sind ebenfalls wieder zu Zellen zusammengefaßt und werden über ein nebeneinander laufendes Endlosband 14 versorgt. In den Zellen selbst sind ebenfalls wieder horizontal laufende Endlosbänder angeordnet. Vor der Prüfung müssen die einzelnen Baugruppen noch durch die Endmontage 35 eine Zelle für die Zusatzverdrahtung 37 und über eine IC-Test-Zelle 36 geführt werden.

Die Versorgung der einzelnen Stationen mit Bauelementen und Bauteilen wird über ein fahrerloses Transportsystem FTS sichergestellt.

Bezugszeichenliste

1 erstes Endlosband
2 zweites Endlosband
3 erste Bearbeitungsstation
4 zweite Bearbeitungsstation
5 dritte Bearbeitungsstation
6 zweiter Streckenkopf
8 erster Streckenkopf
9 Leiterplatte
10 Puffer
11 Lötstationen
12 Transportbänder
13 dritter Streckenkopf
14 drittes Endlosband
15 Prüfstationen
16 Werkstückträgerpufferplatz
17 Lager
19 Lagergassen
20 Regale
21 Regale
22 Bauelementevorbereitungsplätze
WTL Werkstückträger (Löten)
WTB Werkstückträger (Bestückung)
WTP Werkstückträger (Prüfen)
23 Lötautomat
24 Vorrichtung
25 Waschautomat
26 Stapelvorrichtung
27 Abzweigung
28 Einspeisung
29 Reparaturstation
30 Föderband
31 Gerätemontage
33 Hanbestückungsplatz
34 Vormontagezelle
35 Endmontage
36 IC-Testzelle
37 Zusatzverdrahtung
41 Waschanlage
42 Zelle

**Ansprüche**

1. Fertigunsanlage zur automatischen Montage und Prüfung elektronischer Flachbaugruppen unter Verwendung programmgesteuerter Bestückungs-, Löt-und Prüfautomaten sowie eines mechanischen Transportsystems, wobei jeweils mehrere gleichartige Bearbeitungsstationen zu sogenannten Zellen zusammengefaßt sind, wobei die Steuerung der Einzelteile, wei z. B. Leiterplatten, Bauelemente oder mechanische Teile, über einen Leitrechner in Zusammenarbeit mit jeder Zelle zugeordneten Zellenrechnern und Hilfe an den Einzelteilen anbringbaren Kennzeichnungen erfolgt, **dadurch gekennzeichnet,** daß der erste Teil des Transportsystems aus zwei übereinander angeordneten getrennten horizontalen Endlosbändern (1, 2) zum getrennten Transport von Leiterplattern bzw. Flachbaugruppen und den damit zu bestückenden Bauteilen, mit seitlich in Transportrichtung über vom Leitrechner gesteuerten Weichen erreichbaren Bearbeitungsstationen (3, 4, 5) sowie einem ersten Streckenkopf (8) besteht, auf dem die wie einem ersten Streckenkopf (8) besteht, auf dem die Leiterplatten (9) auf einen ersten mit einer erstn Zieladresse versehenen Werstückträger (WTB) zur Bestückung aufbringbar sind, wobei in jeder Bearbeitungsstation - (3, 4, 5) Mittel vorgesehen sind, durch die die erreichte Zieladresse löschbar und die jeweils neue Zieladresse aufbringbar ist, daß an diesem ersten Streckenkopf (8) außerdem die Bauteile einzeln oder satzweise ebenfalls mit ihrer Zieladresse versehbar sind, daß in den Bearbeitungsstationen (3, 4, 5) außerdem Puffer (10) zur Ablage aufgelaufener, zur bestückender Leiterplatten bzw. Flachbaugruppen und Bauteile vorgesehen sind, daß ein zweiter Streckenkopf (6) vorgesehen ist, an dem die teilbestückten Flachbaugruppen auf einem zweiten, die letzte Zieladresse übernehmenden, Werkstoffträger (WTI) zum Löten umsetzbar sind, von dem aus sie dem zweiten Teil des Transportsystems, das zu den Lötstationen (11) führt und aus einer oder mehreren nebeneinander angeordneten Transportbändern (12) besteht, zugeführt sind, daß ein dritter Streckenkopf (13) vorgesehen ist, an dem die von der Lötstation (11) kommenden bestückten Flachbaugruppen auf einem dritten Werkstückträger (WTP) für Prüfzwecke umgesetzt, auf den dritten Teil des Transportsystems, das aus einem in einer Ebene angeordneten Endlosband - (14) besteht, den Endmontage-und Prüfstationen (15) zugeführt sind.

2. Fertigungsanlage zur automatischen Montage und Prüfung elektronischer Flachbaugruppen unter Verwendung programmgesteuerter Bestückungs-, Löt-und Prüfautomaten sowie eines mechanischen Transportsystems, wobei jeweils mehrere gleichartige Bearbeitungsstationen zu sogenannten Zellen zusammengefaßt sind, wobei die Steuerung der Einzelteile, wie z.B. Leiterplatten, Bauelemente oder mechanische Teile, über einen Leitrechner in Zusammenarbeit mit jeder Zelle zugeordneten Zellenrechnern und mit Hilfe an den Einzelteilen anbringbaren Kennzeichnungen erfolgt, **dadurch gekennzeichnet**, daß der erste Teil des Transportsystems aus einem übereinander angeordneten Endlosband (43) zum Transport von Leiterplatten bzw. Flachbaugruppen , mit seitlich in Transportrichtung über vom Leitrechner gesteuerten Weichen erreichbaren Bearbeitungsstationen - (3, 4, 5) sowie einem ersten Streckenkopf (8) besteht, auf dem die Leiterplatten (9) auf einen ersten mit einer ersten Zieladresse versehenen Werkstückträger (WTB) zur Bestückung aufbringbar sind, wobei in jeder Bearbeitungsstation (3, 4, 5) Mittel vorgesehen sind, durch die die erreichte Zieladresse löschbar und die jeweils neue Zieladresse aufbringbar ist, daß in den Bearbeitungsstationen (3, 4, 5) außerdem Puffer (10) zur Ablage aufgelaufener, zu bestückender Leiterplatten bzw. Flachbaugruppen und Bauteile vorgesehen sind und daß die Bauteile über ein fahrerloses Transportsystem (FTS) zu den einzelnen Bearbeitungsstationen gelangen, daß ein zweiter Streckenkopf - (6) vorgesehen ist, an dem die teilbestückten Flachbaugruppen auf einem zweiten, die letzte Zieladresse übernehmenden, Werkstoffträger (WTL) zum Löten umsetzbar sind, von dem aus sie dem zweiten Teil des Transportsystems, das zu den Lötstationen (11) führt und aus einer oder mehreren nebeneinander angeordneten Transportbändern (12) besteht, zugeführt sind, daß ein dritter Streckenkopf (13) vorgesehen ist, an dem die von der Lötstation (11) kommenden bestückten Flachbaugruppen auf einem dritten Werkstückträger (WTP) für Prüfzwecke umgesetzt, auf den dritten Teil des Transportsystems, das aus einem horizontal angeordneten Endlosband (14) besteht, den Endmontage-und Prüfstationen (15) zugeführt sind.

FIG 1

Datensichtstation

0 229 256

FIG 2

0 229 256

FIG 3